# EUROPEAN PATENT SPECIFICATION

(11) **EP 2 916 919 B1**
(45) Date of publication and mention of the grant of the patent: **08.03.2017**
(21) Application number: 13803279.2
(22) Date of filing: 12.11.2013
(51) Int. Cl.: A62C 3/16, A62C 5/00, A62C 37/36, H05K 7/14

(54) **METHOD AND SYSTEM TO AVOID FIRE OF AN ELECTRICAL DEVICE**
VERFAHREN UND SYSTEM ZUM VERMEIDEN VON BRÄNDEN EINER ELEKTRISCHEN VORRICHTUNG
PROCÉDÉ ET SYSTÈME POUR ÉVITER LE FEU D'UN DISPOSITIF ÉLECTRIQUE

(30) Priority: 12.11.2012 NL 2009789
(43) Date of publication of application: 16.09.2015
(73) Proprietor: Exxfire B.V., 2596 AC The Hague (NL)
(72) Inventor: BOTTER, Harm Johan Christiaan, 2596 AC The Hague (NL); SANDERS, Hubertus Maria, 2498 DS The Hague (NL)
(74) Representative: Krebs, Achim
(86) International application number: PCT/NL2013/050808
(87) International publication number: WO 2014/073970

(56) References cited:
- EP-A1- 2 070 870
- WO-A1-2011/161792
- WO-A2-2005/110548
- DE-A1-102004 029 655
- JP-A- 2001 346 898
- JP-A- 2006 334 064
- US-A- 5 936 531
- US-A1- 2007 103 325

## Description

The invention is directed to a method to avoid a fire in an electrical device which is connected to a source of electrical power. The invention is also directed to a system which avoids overheating of an electrical device, thereby avoiding or limiting fire.

Data centres are parts of buildings or facilities in which a large number of computing and networking IT equipment, such as server computers, are mounted in racks that are arranged in the data centre. The dense packing of the server computers results in the generation of a large amount of heat in a localized area.

Too much heat may cause premature equipment failure. As a result, the data centre must be cooled in a reliable manner in order to avoid the shutting down of, or damage to, the server computer hardware. Shutting down of server computers due to heat overload can cause significant economic loss.

Computers often short circuit causing small fires in the computer. In the event of a high impedance short circuit inside a server or other computer, the power supply over-current detection may not function properly. Since the power supply doesn't detect such an over-current condition, the power supply continues to supply current. Depending on the location of the short on the system board, a fire can result until either the high impedance short opens completely or shorts completely, at which time the power supply over-current detection circuit shut the power supply down. Such small fires in a server or other computer often do not produce enough smoke to set off a smoke detector mounted in the room where the server is placed until the fire has spread to the point of endangering other servers and computers.

To cool and control humidity of the racks of the data centre, air conditioning systems, often specialized cooling units, have been developed for implementation directly in data centres. The specialized cooling units are sometimes known in the art as computer room air conditioning units ("CRACs") or computer room air handling units. One of the main challenges of cooling data centres is the air conditioning system. The system is often operated at or near maximum cooling and/or power while some racks and/or servers are still running too hot.

While certain air conditioning system arrangements provide a solution to the need for enhanced cooling power within a data centre, there is nevertheless a danger of individual server computers overheating and catching fire, due to at least imbalanced loading of processing tasks within the data centre, malfunction, misallocation or inefficiency of the air conditioning system. Overheating of individual server computers can result in fire. Adequate response to overheating and fire of individual server computers is thus desired for safety reasons.
US2010/0076607 describes a system wherein the local temperature in a data centre is measured and used as input to locally enhance the cooling of the equipment present in the data centre. A disadvantage of this system is that a complicated array of sensors, a central control and separate cooling air supplies are required. Another disadvantage is that in case of a rapid over heating the air cooling may not be sufficient to avoid the start of a fire.
EP-A-2070870 discloses a solid, porous material, suitable for generating nitrogen gas, said material having a porosity of 20 to 75 vol.%, and a composition comprising, based on the weight of the material of 60 to 90 wt.% of sodium azide, 0.1 to 20 wt.% of an inert chemical coolant based on at least one inorganic salt having a heat capacity of at least 900 J/K/kg, 0.1 to 20 wt.% of modifying agent selected from metal oxides and metal carbonates, and a binder, selected from the group consisting of at least one alkali metal silicate, preferably waterglass, or a poly-tetrazole, in an amount of between 3 and 15 wt.%.
JP-A-2001346898 discloses an extinguishing apparatus for fire quenching, by discharging a fire extinguisher gas from a gas generating agent installed for generating the fire extinguisher gas through a reaction produced by an ignition device igniting at a time of a fire and ignition thereof.
JP-A-2006334064 discloses an automatically triggered fire extinguishing device for electrical apparatus comprising an electrically sensor for at least one of atmospheric temperature, smoke, flame and combustible gas and a fire extinguishing function for spraying a fire extinguishing agent in linkage with the sensing, in particular phosphate.
WO 2005/110548 A2 discloses a device for protecting an inner space of an object against fire, comprising: a housing provided with at least one passage opening; - an aerosol-forming extinguishing element arranged in the housing and which comprises: a container for holding extinguishing material which can be activated at a fixed activating temperature; at least one outlet opening which can be connected to the passage opening in the housing and along which the activated extinguishing material can be carried into the inner space of the object so as to extinguish the fire; - an activating element for bringing at least part of the extinguishing material to the activation temperature; at least one detection unit arranged in or close to the housing for detecting at least one physical and/or chemical parameter representative of fire in the inner space; and a control unit arranged in the housing for causing thermal activation of the extinguishing element by the activating element when a preset activation value of the detected physical and/or chemical parameter is reached, wherein the housing is embodied for placing in the inner space of the object.
US-A-5936531 discloses an electrical fire sensing and fire prevention/extinguishing system which senses properties of electrical fires in cabinets having electrical circuits or circuit boards and detects sparks for detecting an electrical short in the electrical circuits or circuit boards. Upon detecting a spark, power to the electrical circuits or circuit boards is turned off to prevent a fire from developing within the cabinet.
DE102004029655 discloses a fire protection device for personal computer, has construction units that are formed as plug-in module due to their dimension and arrangement and sensor triggering notification and extinguish function simultaneously with certain delay.
EP2586496 discloses a disaster-preventing device provided with: a battery that supplies a power source; a fire detecting unit that detects fire; and an aerosol generating unit that generates and discharges, to outside, aerosol for extinguishment by combustion of a solid extinguishing agent when the fire detecting unit detects the fire. US2007103325 discloses an apparatus for fire detection in an electrical equipment rack includes a suction pipe system which communicates with the rack monitored through at least one suction opening and through which a representative air sample is drawn from the rack, an early fire detection module having at least one detector unit for detecting at least one fire parameter in the air sample extracted through the suction pipe system, and a controller for issuing an early fire detection signal in response to the result detected with the at least one detector unit.

Fire fighting systems for data centres are known and comprise of smoke and/or flame sensors mounted inside the room where the servers are located to detect a fire and a fire extinguishing system comprising of bottled gas. The sensors are mounted at a considerable distance from the servers themselves.

A disadvantage of these known systems is that they are activated only after detecting a fire by the external sensor. This is disadvantageous because considerable damage may already have occurred. Another disadvantage is that all of the equipment in the data centre is exposed to the fire extinguishing gas, likely causing damage to equipment which initially was not damaged by the local fire. Another disadvantage is the long time period between detection of a fire and extinguishing said fire. The present invention aims to provide a system and method which avoids damage to an electrical device as a result of a fire.

This is achieved by the following system and method: A system comprising (i) an electrical device connected to a source of electrical power; (ii) a container comprising a solid propellant gas generator, an igniter and a filter positioned between the solid propellant gas generator and an outflow opening for a gas, which outflow opening is fluidly connected to the electrical device; (iii) means to detect fire indicator levels, comprising means to detect a temperature, a carbon monoxide level and/or a smoke particle level in the electrical device; and (iv) a control system having a control logic which, when two of the three fire indicators levels as measured by means (iii) are above threshold values, will cut off the source of electrical power, and which will actuate the igniter after a predetermined delay time.

In a further aspect, the present invention also relates to a method to avoid a fire in an electrical device which is connected to a source of electrical power by (a) measuring a fire indicator level, comprising measuring temperature, a carbon monoxide level and/or a smoke particle level in the electrical device; (b) when two of the three fire indicator levels as measured in step (a) are above threshold values, the source of electrical power will be cut off from the electrical device; and (c) a flow of inert gas as generated by a solid propellant gas generator is supplied to the electrical device after a predetermined delay time.

Applicants found that with the above system and method it is possible to avoid a fire in an electrical device by supplying an inert gas when overheating or initiation of fire of the electrical device or its components is detected. Overheating of an electrical device may cause a fire due to the volatile and flammable gasses as generated in such a device at the temperatures of overheating. By supplying the inert gas these flammable gasses and oxygen will be transported away from the overheated electrical device and the risk that fire will occur or will spread to the vicinity of the electrical device will be lowered.

Another advantage is that the present system and method avoids the need for a complicated system as in US2010/0076607. Another advantage is that the method and system provide a local solution for an individual electrical device, thereby avoiding that other devices in the vicinity are fully exposed to a fire extinguishing gas. It also enables one to suppress overheating or spread of fire of one piece of equipment as part of a group of electrical devices, for example the electrical devices in a data centre, while the remaining electrical devices can continue to perform. Other advantages of the invention will be discussed when describing the preferred embodiments here below.

It was further found that it is advantageous to only supply the inert gas after a certain delay time from cutting off the source of electrical power. In this manner any gas circulation in the electrical device resulting from cooling fans and the like will be reduced. This will enhance that the inert gas supplied to the electrical device will remain in said device and not transported away from the device by these gas circulations. Preferably the delay time is between 1 and 10 seconds.

The electrical devices which are part of the system may be any type of electrical device. Suitably the electrical device is a device which may catch fire when overheating occurs. Electrical devices may be devices which use and/or generate electricity. Suitably the electrical device is connected to a source of power. Examples of electrical devices are household equipment, like for examples washing machines, dryers, personal appliances, like for example personal computers and audio equipment, batteries, medical equipment, like for example radio-diagnostic equipment, vehicle, e.g. land, sea and air vehicle, electrical equipment, like for example on-board computers, batteries, fuel cells.

The electrical device may be server computers, which typically comprise one or more of processors, micro-controllers, high speed video cards, memories, storage such as random access memory (RAM), network interfaces and controllers, semi-conductor devices, disk drives, small computer interface (SCSI) bus controllers, video controllers, power supplies and the like, and one or more subsystems. The server computers are operable to perform various applications, such as computing, switching, routing, displaying, and the like. The electrical device may also be so-called UPS and PDU units and memory storage equipment, like for example hard disks. Such electrical devices are preferably located in one space and positioned in so-called racks. The electrical device is suitably fitted in a server rack which itself can be fitted in a container. This container may conveniently have a shape suitable to accommodate the electrical device, and accommodate for other necessary components, such as e.g. cooling fans. Typically such containers have a rectangular, box like shape. The container typically also is in fluid connection to the environment, to allow for air flow over the components for cooling purposes, by means of one or more ventilation openings. The space, i.e. a data centre, is preferably cooled by means of air. The data centre may also be composed of several modules, each module comprising one or more of the above described equipment. For example each module may be a shipping container as for example described in US7278273.

In a preferred embodiment more than one electrical device is provided with the container comprising a solid propellant gas generator. Preferably the above described container comprising the electrical device is connected to the container comprising the solid propellant gas generator. In this manner a local and individual cooling and fire suppression of the electrical device present in the box like container can be achieved. It can be envisaged that only one container comprising the solid propellant gas generator is actuated to discharge the inert gas to the electrical device to which it is connected, while neighbouring systems are not actuated and continue to function normally. When the electrical devices are fitted in a container and wherein containers are placed in a server rack it is possible to position the container comprising a solid propellant gas generator, an igniter and a filter at the back side or the front of the server rack. In may be advantageous to place the gas generator at the front side in order to avoid interference with the cabling typically present at the back side of such a server rack.

In another embodiment the data centre is composed of several modules as described above and wherein one or more containers comprise a system according to the invention. The temperature, carbon monoxide level and smoke particle level as measured in one or more of the electrical devices as present in one such module may trigger the actuation of a flow of inert gas from the solid propellant gas generator to a single electrical device. In addition a system comprising a, suitably larger, container comprising the solid propellant gas generator, an igniter and a filter may be present in a module which can generate enough inert gas to fill the entire space of a single module. Actuation of such a solid propellant gas generator may be used as a back-up to further avoid or limit fire in the electrical devices as present in the module.

Thus a preferred system is one wherein the electrical device is positioned in a container and wherein this container is connected to one container comprising a solid propellant gas generator and wherein more than one of such containers comprising the electrical devices are placed in a rack. The rack may be part of a server data centre. The individual electrical devices may be the earlier referred to processors, micro-controllers, high speed video cards, memories, storage such as random access memory (RAM), network interfaces and controllers, semi-conductor devices, disk drives, small computer interface (SCSI) bus controllers, video controllers, power supplies and the like, and one or more subsystems.

More preferably the system comprises a data centre comprising a multitude of racks, wherein the racks comprises servers individually connected to a source of power, individually provided with the container comprising a solid propellant gas generator and individually provided with the means to detect fire indicator levels and individually provided with the control system which has a control logic to ignite the igniter of the container comprising a solid propellant gas generator of the individual server and cut off the source of electrical power of the individual server.

The above system may also comprise one or more disk storage systems, one or more transformer units and/or one or more memory storage devices, individually provided with the container comprising a solid propellant gas generator and individually provided with the means to detect fire indicator levels and individually provided with the control system which has a control logic to ignite the igniter of the container comprising a solid propellant gas generator of these individual electrical devices and cut off the source of electrical power of the individual electrical device.

Solid propellant gas generators are known. Preferred solid gas generators generate an inert gas, such as suitably carbon dioxide and nitrogen. A preferred solid propellant gas generator comprises a solid sodium azide containing composition. Such compositions which are able to generate a nitrogen gas are known and for example described in WO2009/078707. This publication discloses a suitable composition to be used in the present invention because said composition can generate a cool, i.e. less than 90 °C, more suitably less than 40 °C, nitrogen gas of a high purity. Applicants have found that the temperature of the gas which is generated will depend on the temperature of the environment and is typically within 15 °C of said ambient temperature. Applicant further found that the inert gas as generated will be suitably be between -2 and 10 °C above the temperature of the solid propellant gas generator itself. The minus 2 degrees Celsius above the cited temperature means 2 degrees Celsius below the cited temperature. In use the temperature of the solid gas propellant will be the temperature of the air surrounding the electrical device. It will be understood that this temperature will be higher when the solid propellant gas generator is positioned at the outflow opening of the optional cooling fans of an electrical device and lower when the solid propellant gas generator is positioned at for example the front side, sometimes referred to as the cool side, of a server rack. In both situations the temperature of the inert gas as generated will be within a range which will reduce or avoid a thermal shock when the inert gas is supplied to the electrical device. In a preferred system the container is spaced away from the electrical device such that the temperature of the nitrogen gas as generated will be somewhat lower than the temperature of the overheated electrical device. This is advantageous because some cooling will result when this gas is supplied to the interior of the electrical device.

The composition comprising solid sodium azide containing is preferably a solid, porous material, suitable for generating nitrogen gas, said material having a porosity of 20 to 75 vol.%, and a composition comprising, based on the weight of the total composition of from 60 to 90 wt.% of sodium azide, and further comprises a coolant, a binder and a modifying agent. Porosity is defined as the percentage of the free volume relative to the volume of the solid porous material, wherein the free volume is the difference between the volume of the solids used to prepare the porous material and the porous material itself. The porosity is homogeneously distributed in the solid material, thereby enabling the generated gas to pass through the pores of the solid material.

Preferably the solid sodium azide containing composition comprises of between 0.1 to 20 wt.% of the coolant. Preferred coolants are inorganic salts having a heat capacity of at least 1400 J/K/kg as determined at 600 K in order to provide sufficient cooling. Further, the coolant has an important function as slag modifier. Because of its properties it helps keeping the slag, after the functioning of the gas generator, in place. In a preferred embodiment the heat capacity of the coolant is at least 1900 J/K/kg. The coolant should be inert, which means that it does not decompose or react with the other components in the charge, at the reaction temperature of the gas generation. This means that hydroxides and carbonates cannot be used herein, as they are unsuitable. The coolant is preferably one or more compounds selected from LiF, Li₂O, Li₂C₂, Li₃N₃, Li₂SO₄, Li₂B₂O₄, Li₂B₄O₇ and Li₂SiO₃. Preferred are the lithium compounds in view of the superior combined properties in relation to slag modifier and coolant.

Preferably the composition comprising solid sodium azide further comprises of from 0.1 to 20 wt.% of the modifying agent. Preferred modifying agents or burning modifier is selected from metal oxides and metal carbonates. Generally, these modifying agents do not have the high heat capacity of the cooling agent. Further, the modifying agent either reacts exothermically in the system, or has a catalytic function. As modifying agent preferably ferric oxide (Fe₂O₃) or sodium carbonate (Na₂CO₃) are used.

The composition comprising solid sodium azide suitably comprises a binder, selected from the group consisting of at least one alkali metal silicate, preferably water glass, or a poly-tetrazole, in an amount of between 3 and 15 wt.% based on total weight of the composition.

The igniter may be any device which triggers the combustion of the solid propellant composition by any suitable means. The igniter may be of a classical pyrotechnic type, but it is also possible to use other (conventional) igniters. The igniter is positioned such that the composition can be ignited and nitrogen gas is generated.

To assure that the gas generator does not discharge sodium, or reaction products thereof, and that the gases do not contain particulate material or unwanted chemical pollutants, the gas generator is provided with a filter that filters out sodium and any other unwanted pollutant and solid or liquid material. Suitable filters comprise granular material, such as activated carbon, sand, zeolite, metal oxides, and combinations thereof, either in admixture with each other or consecutively.

Preferably the gas generator delivers inert gases with an inert gas content of at least 85 vol.%, preferably at least 95 vol.%. In the case nitrogen gas is generated it is preferred that the gas contains flammable or combustible gases in concentrations far below their lower flammability limit in air, and preferably the concentration of methane is lower than 0.2 vol.%, the concentration of hydrogen is lower than 1.0 vol.%, the concentration of carbon monoxide is lower than 0.02 vol.%, the concentration of ammonia in the discharged gases is preferably lower than 0.05 vol.%.

The means to detect fire indicator levels, comprising means to detect a temperature, a carbon monoxide level and a smoke particle level in the electrical device may be present in the device or just outside the device. Suitably these means are integrated in the container comprising the solid propellant gas as connected to the electrical device. The means to detect fire indicator levels, comprising means to detect a temperature, a carbon monoxide level and a smoke particle level in the electrical device may be well known means to the skilled person.

Common knowledge may be applied to choice the suitable means for each application and set the threshold values. The threshold value for temperature may be between 50 and 125 °C. A possible threshold value for smoke particle level is 500000 smoke particles per cubic cm. In case of the carbon monoxide level detection and/or the smoke particle level detection the threshold value may be a fixed value or may be the increase of the detected level within a small time period. For example an increase of 5 ppm for the carbon monoxide level within a small period of time, for example one minute, may be indicative for the presence of a starting fire. The means to detect the temperature may be well known means like for example thermo couples or infra red sensors.

The means to detect carbon monoxide may be chemical carbon monoxide sensors. The means to detect smoke particles may comprise an optical sensor or be an ionization smoke detector.

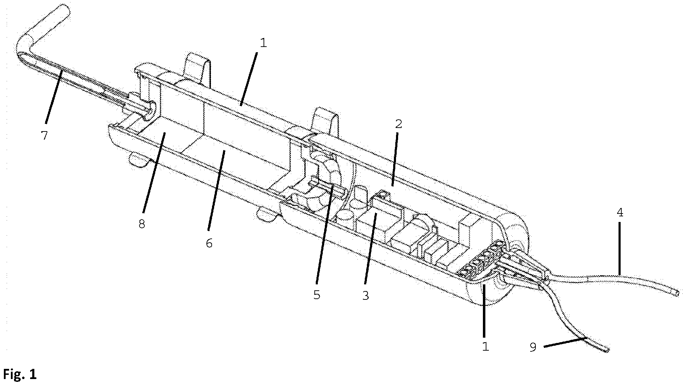

An example of a suitable container is shown in Figure 1. Figure 1 shows a tubular container 1 provided with a space 2 for electronics 3. The electronics are connected to sensor 4 for detecting the temperature, carbon monoxide and/or smoke particle level, e.g. a thermo couple, a smoke detector and/or a carbon monoxide sensor, to detect the values for temperature, carbon monoxide and/or smoke particle level in the electronic device, and connected to igniter 5. The electronics 3 also comprise a logic controller as described above. Igniter 5 is in contact with a space containing the solid propellant gas generator 6. Between outflow opening 7 and the solid propellant gas generator 6 a filter material 8 is present. The wall of the tubular container 1 may be made from stainless steel. Also show is a power connector 9 which provides power for electronics 3.

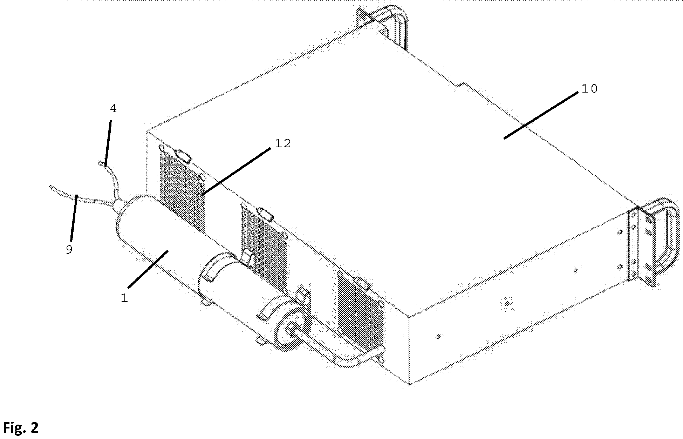

In Figure 2 tubular container 1 is fitted on the back side of a server 10. The outflow opening for nitrogen gas is fluidly connected to the interior of the server 10 by means of a conduit 11. Through conduit 11 nitrogen gas can flow into the server in case of overheating or starting fire. Also shown is that the power supply for tubular container 1 is provided by connecting power connector 9 to a power supply of the server 10. Sensors 4 to detect the temperature, carbon monoxide level or smoke particle level within the server may be positioned at the cooling air outlet 12 of server 10.

The invention is also directed to a method to avoid a fire in an electrical device which is connected to a source of electrical power by (a) measuring a fire indicator level, comprising measuring temperature, a carbon monoxide level and a smoke particle level in the electrical device; (b) when two of the three fire indicator levels as measured in step (a) is above a threshold value the source of electrical power will be cut off from the electrical device; and (c) a flow of inert gas as generated by a solid propellant gas generator is supplied to the electrical device after a predetermined delay time.

The threshold value for temperature, carbon monoxide and smoke particle at which the step (c) is performed will be dependant on when the electrical device is actually damaged by overheating and when the first components of the electrical device start to smoulder or even catch fire. These threshold values can be well known values in the art for actuating fire alarms which are based on temperature, smoke and carbon monoxide measurements.

The solid propellant gas generator is preferably as described above. In case a natrium azide based propellant is used it is found that the temperature of the nitrogen gas as generated will be close to the ambient temperature at which the solid propellant gas generator is operated. In a typical situation the temperature of the nitrogen gas may be below 60 °C. Thus the temperature of the solid propellant gas as supplied to the electrical device will be near to the ambient temperature surrounding the device. This will avoid a temperature shock and thus any damage resulting from a temperature shock. Thus even in the event of a false call the use of the system or method will not result in a temperature shock as in a situation wherein bottled and pressurised gas is used. This will enable one to accept false calls because no or a low risk of damage is accepted. By accepting false calls a threshold values of the sensors may be chosen closer to the working temperature, carbon monoxide and smoke particle levels of the electrical device making the system more robust and lower significantly the risk of fire.

The preferred nitrogen containing gas is preferably prepared in step (c) in-situ from a solid sodium azide containing composition as described above. Preferably the nitrogen containing gas is generated in a container containing the solid sodium azide containing composition as described above. Once two of the three of the temperature, carbon monoxide level or smoke particle level have reached the threshold value the igniter of said container is actuated and a nitrogen containing gas is generated which can be supplied to the electrical device. In a preferred embodiment the method is performed in the system described above.

### Example

A container was filed with a composition as described in WO2009/078707 having a porosity of 50 vol% and containing 79 wt% NaN₃, 7 wt% K-silicate, 3 wt% Fe₂O₃ and 11 wt% LiF. The container was ignited at different temperatures of the gas propellant gas generator itself. In every experiment the temperature of the nitrogen gas as discharged was measured. From the results presented in the below Table it follows that the temperature of the gas is close to the temperature of the solid sodium azide.

| Temperature solid sodium azide (°C) before ignition | Temperature of the nitrogen gas (°C) |
|---|---|
| -3 | -3 |
| 19 | 19 |
| 37 | 42 |

## Claims

1. System comprising
(i) an electrical device connected to a source of electrical power (9);
(ii) a container (1) comprising a solid propellant gas generator (6), an igniter (5) and a filter (8) positioned between the solid propellant gas generator (6) and an outflow opening (11) for a gas, which outflow opening is fluidly connected to the electrical device;
(iii) means (4) to detect fire indicator levels, comprising means to detect a temperature, a carbon monoxide level and/or a smoke particle level in the electrical device; and
(iv) a control system having a control logic which, when two of the three fire indicators levels as measured by means (iii) are above threshold values, will cut off the source of electrical power (9), and which will actuate the igniter (5) after a predetermined delay time, preferably wherein the predetermined delay time is between 1 and 10 seconds.

2. System according to claim 1, wherein the electrical device is positioned in a container and wherein said container is connected to said container (1) comprising the solid propellant gas generator (6) and, wherein said container can be placed in a rack with a plurality of containers.

3. System according to any one of claims 1-2, wherein the electrical device is a server (10) or a disk storage system, and preferably, wherein the system comprises a data centre comprising a multitude of racks, wherein the racks comprises servers (10) individually connected to a source of power (9), individually provided with the container (1) comprising a solid propellant gas generator (6) and individually provided with the means (4) to detect fire indicator levels and individually provided with the control system which has a control logic to ignite the igniter (5) of the container (1) comprising a solid propellant gas generator of the individual server and cut off the source of electrical power of the individual server.

4. System according to claim 3, wherein the data centre also comprises one or more disk storage systems, one or more transformer units and/or one or more memory storage devices, individually provided with the container (1) comprising a solid propellant gas generator (6) and individually provided with the means (4) to detect fire indicator levels and individually provided with the control system which has a control logic to ignite the igniter (5) of the container (1) comprising a solid propellant gas generator (6) of these individual electrical devices and cut off the source of electrical power (9) of the individual electrical device.

5. System according to any one of claims 1 -4, wherein the solid propellant gas generator (6) comprises a composition comprising sodium azide.

6. System according to claim 5, wherein the composition comprising sodium azide is a solid, porous material having a porosity of 20 to 75 vol.%, and is a composition comprising, based on the weight of the total composition of from 60 to 90 wt.% of sodium azide, and further comprises an coolant, a binder and a modifying agent, and preferably, wherein the composition comprising sodium azide further comprises between 0.1 to 20 wt% of the modifying agent selected from metal oxides and metal carbonates, and between 3 and 15 wt% of a binder selected from an alkali metal silicate or a poly-tetrazole, based on total weight of the composition.

7. System according to claim 6, wherein the composition comprising sodium azide comprises of from 0.1 to 20 wt.% of the coolant, wherein the coolant is an inorganic salt having a heat capacity of at least 1400 J/K/kg.

8. System according to any one of claims 1-7, wherein the container (1) comprises a logic controller which is set to actuate the igniter (5) once the means (4) to measure the temperature of the electrical device reaches a set threshold value.

9. System according to any one of claims 1-8, wherein the electrical device is connected to a source of electrical power (9) and wherein the control system has a control logic which, when a temperature is measured by means (4) (iii) above a threshold value, will cut off the source of electrical power (9) and which will actuate the igniter (5).

10. Method to avoid a fire in an electrical devic6 which is connected to a source of electrical power (9) by
(a) measuring a fire indicator level, comprising measuring temperature, a carbon monoxide level and /or a smoke particle level in the electrical device;
(b) cutting off the source of electrical power (9) from the electrical device (3) when two of the three fire indicator levels as measured in step (a) are above threshold values; and
(c) supplying a flow of inert gas as generated by a solid propellant gas generator (6) to the electrical device after a predetermined delay time, preferably wherein the predetermined delay time between 1 and 10 seconds.

11. Method according to claim 10, wherein the inert gas has a temperature of between 2 and 10 °C above the temperature of the solid propellant gas generator (6).

12. Method according to any one of claims 10-11, wherein the inert gas is nitrogen gas which is
prepared in-situ from a composition comprising solid sodium azide, and preferably, wherein the composition comprising sodium azide is a solid, porous material having a porosity of 20 to 75 vol.%, and is a composition comprising, based on the weight of the total composition of from 60 to 90 wt.% of sodium azide, and further comprises an coolant, a binder and a modifying agent.

13. Method according to claim 12, wherein the composition comprising sodium azide comprises of from 0.1 to 20 wt.% of the coolant, wherein the coolant is an inorganic salt having a heat capacity of at least 1400 J/K/kg.

14. Method according to any one of claims 12-13, wherein the composition comprising sodium azide further comprises between 0.1 to 20 wt% of the modifying agent selected from metal oxides and metal carbonates, and between 3 and 15 wt% of a binder selected from an alkali metal silicate or a poly-tetrazole, based on total weight of the composition.

15. Method according to any one of claims 10-14 as performed in a system according to claims 1-9.

## Patentansprüche

1. System, umfassend (i) eine elektrische Vorrichtung, welche mit einer elektrischen Stromquelle (9) verbunden ist; (ii) einen Behälter (1) mit einem festen Treibgasgenerator (6), einem Zünder (5) und einem zwischen dem festen Treibgasgenerator (6) und einer Ausströmöffnung (11) für ein Gas angeordneten Filter (8), wobei die Ausströmöffnung in Fluidverbindung mit dem elektrischen Gerät verbunden ist; (iii) eine Einrichtung (4) zum Erfassen von Brandanzeigeniveaus, umfassend Mittel zum Erfassen einer Temperatur, eines Kohlenmonoxidpegels und / oder eines Rauchpartikelniveaus in der elektrischen Vorrichtung; und (iv) ein Steuersystem mit einer Steuerlogik, die, wenn zwei der drei durch die Einrichtung (iii) gemessenen Brandanzeigeniveaus oberhalb von Schwellenwerten liegen, die Stromquelle (9) abschaltet und die den Zünder (5) nach einer vorbestimmten Verzögerungszeit betätigt, wobei vorzugsweise die vorbestimmte Verzögerungszeit zwischen 1 und 10 Sekunden beträgt.

2. System gemäß Anspruch 1, wobei die elektrische Vorrichtung in einem Behälter angeordnet ist, und wobei der Behälter mit dem Behälter (1) verbunden ist, welcher den Feststofftreibgasgenerator (6) enthält, wobei der Behälter in einem Rack mit einer Vielzahl von Behältern angebracht werden kann.

3. System gemäß eines der Ansprüche 1-2, wobei die elektrische Vorrichtung ein Server (10) oder ein Plattenspeichersystem ist, und vorzugsweise, wobei das System ein Rechenzentrum mit einer Vielzahl von Racks umfasst, wobei die Racks Server (10) enthalten, die jeweils individuell mit einer Energiequelle (9), mit dem einen Feststofftreibgasgenerator enthaltenden Behälter (1), mit der Einrichtung (4) zum Erfassen von Brandanzeigeniveaus versehen, und mit der Steuereinrichtung verbunden sind, welche eine Steuerlogik umfasst um den Zünder (5) des einen Feststofftreibgasgenerator des jeweiligen einzelnen Servers enthaltenden Behälter (1) zu zünden, und um die elektrische Stromquelle (9) des jeweils einzelnen Server abzuschneiden.

4. System gemäß Anspruch 3, wobei das Datenzentrum auch ein oder mehrere Plattenspeichersysteme, eine oder mehrere Transformatoreinheiten und/oder ein oder mehrere Festspeichergeräte umfasst, welche individuell mit dem einen Feststofftreibgasgenerator (6) enthaltenden Behälter (1), und individuell mit der Einrichtung (4) zum Erfassen von Brandanzeigeniveaus, und individuell mit dem Steuersystem versehen sind, welches eine Steuerlogik umfasst, um den Zünder (5) des einen Feststofftreibgasgenerator enthaltenden Behälters (1) dieser jeweiligen einzelnen elektrischen Apparate zu zünden, und um die elektrische Stromquelle (9) der jeweiligen elektrischen Apparate abzuschneiden.

5. System gemäß eines der Ansprüche 1-4, wobei der Feststofftreibgasgenerator (6) eine Zusammensetzung enthält, die Natriumazid enthält.

6. System gemäß Anspruch 5, wobei die Natriumazid enthaltende Zusammensetzung ein festes, poröses Material mit einer Porosität von 20 bis 75 Volumen% ist, und eine Zusammensetzung aufweist, welche, bezogen auf das Gewicht der Gesamtzusammensetzung, von 60 bis 90 Gewichts% an Natriumazid, und des weiteren ein Kühlmittel , ein Bindemittel und ein Modifizierungsmittel umfasst, vorzugsweise wobei die die Natriumazid enthaltende Zusammensetzung des weiteren zwischen 0.1 und 20 Gewichts% des Modifizierungsmittels ausgewählt aus Metalloxiden und Metallcarbonaten umfasst, und zwischen 3 und 15 Gewichts% eines Bindemittels ausgewählt aus einem Alkalimetallsilikat oder einem Poly-Tetrazol, bezogen auf das Gesamtgewicht der Zusammensetzung, umfasst.

7. System gemäß Anspruch 6, wobei die Natriumazid enthaltende Zusammensetzung von 0.1 bis 20 Gewichts% des Kühlmittels enthält, wobei das Kühlmittel ein anorganisches Salz mit einer Wärmekapazität von mindestens 1400 J/K/kg ist.

8. System gemäß eines der Ansprüche 1-7, wobei der Behälter (1) eine Logiksteuerung umfasst, die eingestellt ist, um den Zünder (5) zu betätigen, sobald die Einrichtung (4) zur Temperaturbestimmung der elektrischen Vorrichtung einen vorgewählten Schwellenwert erreicht.

9. System gemäß eines der Ansprüche 1-8, wobei die elektrische Vorrichtung an eine elektrische Stromquelle (9) angeschlossen ist, und wobei das Steuersystem eine Steuerlogik hat welche, wenn eine Temperatur durch Einrichtung (4) (iii) oberhalb eines Schwellenwertes gemessen wird, die elektrische Stromquelle (9) abschneidet und den Zünder betätigt (5).

10. Verfahren zur Vermeidung eines Feuers in einem elektrischen Gerät, welches mit einer elektrischen Stromquelle (9) verbunden ist, umfassend (a) Messen eines Brandanzeigeniveaus, umfassend eine Temperaturmessung, eine Kohlenmonoxidpegel und / oder ein Rauchpartikelpegel in dem elektrischen Gerät; (b) Abschneiden der Stromquelle (9) von der elektrischen Vorrichtung (3), wenn zwei der drei Brandanzeigeniveaus, die in Schritt (a) gemessenen sind, oberhalb der Schwellenwerte liegen; und (c) Bereitstellen eines Inertgasstromes an die elektrische Vorrichtung, der durch einen Feststofftreibgasgenerator (6) nach einer vorbestimmten Verzögerungszeit erzeugt wird, wobei vorzugsweise die vorbestimmte Verzögerungszeit zwischen 1 und 10 Sekunden liegt.

11. Verfahren gemäß Anspruch 10, wobei das Inertgas eine Temperatur zwischen 2 und 10 °C oberhalb der Temperatur des Feststofftreibgasgenerators (6) hat.

12. Verfahren gemäß eines der Ansprüche 10-11, bei dem das Inertgas Stickstoffgas ist, das in-situ aus einer festes Natriumazid enthaltenden Zusammensetzung hergestellt wird, wobei vorzugsweise die Natriumazid enthaltende Zusammensetzung ein festes, poröses Material mit einer Porosität von 20 bis 75 Volumen% ist, und eine Zusammensetzung aufweist, welche, bezogen auf das Gewicht der Gesamtzusammensetzung, von 60 bis 90 Gewichts% an Natriumazid, und des weiteren ein Kühlmittel, ein Bindemittel und ein Modifizierungsmittel umfasst.

13. Verfahren gemäß Anspruch 12, wobei die Natriumazid enthaltende Zusammensetzung von 0,1 bis 20 Gewichts.% des Kühlmittels enthält, wobei das Kühlmittel ein anorganisches Salz mit einer Wärmekapazität von mindestens 1400 J/K/kg ist.

14. Verfahren gemäß eines der Ansprüche 12-13, wobei die die Natriumazid enthaltende Zusammensetzung des weiteren zwischen 0.1 und 20 Gewichts% des Modifizierungsmittels ausgewählt aus Metalloxiden und Metallcarbonaten umfasst, und zwischen 3 und 15 Gewichts% eines Bindemittels ausgewählt aus einem Alkalimetallsilikat oder einem Poly-Tetrazol, bezogen auf das Gesamtgewicht der Zusammensetzung, umfasst.

15. Verfahren gemäß eines der Ansprüche 10-14,wenn durchgeführt in einem System gemäß der Ansprüche 1-9.

## Revendications

1. Système comprenant
(i) un dispositif électrique connecté à une source d'alimentation électrique (9) ;
(ii) un récipient (1) comprenant un générateur de gaz propulseur solide (6), un allumeur (5) et un filtre (8) positionné entre le générateur de gaz propulseur solide (6) et une ouverture d'écoulement de sortie (11) pour un gaz, ladite ouverture d'écoulement de sortie étant connectée par le fluide au dispositif électrique ;
(iii) un dispositif (4) pour détecter des niveaux d'indicateur d'incendie, comprenant des dispositifs en mesure de détecter une température, un niveau de monoxyde de carbone et/ou un niveau de particules de fumée dans le dispositif électrique ; et
(iv) un système de commande possédant une logique de commande qui, lorsque deux des trois niveaux d'indicateurs d'incendie, mesurés par un dispositif (iii) se trouvent au-dessus de valeurs de seuil, coupent la source d'alimentation électrique (9), et actionnent l'allumeur (5) après un délai prédéterminé, le délai prédéterminé étant de préférence compris entre 1 et 10 secondes.

2. Système selon la revendication 1, le dispositif électrique étant positionné dans un récipient, ledit récipient étant connecté audit récipient (1) comprenant le générateur de gaz propulseur solide (6), et ledit récipient pouvant être placé dans un rack comprenant une pluralité de récipients.

3. Système selon une quelconque des revendications 1-2, le dispositif électrique étant un serveur (10) ou un système de stockage sur disque, et de préférence le système possédant un centre de données comprenant une multitude de racks, les racks comprenant des serveurs (10) connectés individuellement à une source d'alimentation (9) fournie individuellement avec le récipient (1) comprenant un générateur de gaz propulseur solide (6) et dotée individuellement d'une part du dispositif (4) de détection des niveaux d'indicateur de feu, d'autre part du système de commande possédant une logique de commande pour allumer l'allumeur (5) du récipient (1) comprenant un générateur de gaz propulseur solide du serveur individuel et couper la source d'alimentation électrique du serveur individuel.

4. Système selon la revendication 3, le centre de données comprenant également un ou plusieurs systèmes de stockage sur disque, un ou plusieurs transformateurs, et/ou un ou plusieurs dispositifs de stockage de mémoire, dotés individuellement du récipient (1) comprenant un générateur de gaz propulseur solide (6), et dotés individuellement du dispositif (4) de détection de niveaux d'indicateur de feu, dotés individuellement du système de commande possédant une logique de commande pour allumer l'allumeur (5) du récipient (1) comprenant un générateur de gaz propulseur solide (6) de ces dispositifs électriques individuels et couper la source d'alimentation électrique (9) du dispositif électrique individuel.

5. Système selon une quelconque des revendications 1 à 4, le générateur de gaz propulseur solide (6) comprenant une composition comprenant de l'azide de sodium.

6. Système selon la revendication 5, la composition comprenant de l'azide de sodium étant une matière solide et poreuse, avec une porosité comprise entre 20 et 75 % en vol., et étant une composition comprenant, sur la base du poids de la composition totale, de 60 à 90 % en poids d'azide de sodium, et comprenant en outre un réfrigérant, un liant, et un agent modificateur, et de préférence la composition comprenant de l'azide sodium comprenant également de 0,1 à 20 % en poids d'agent modificateur sélectionné parmi des oxydes métalliques et des carbonates métalliques, et de 3 à 15 % en poids d'un liant sélectionné parmi un silicate de métal alcalin ou un poly-tétrazole, en fonction du poids total de la composition.

7. Système selon la revendication 6, la composition comprenant de l'azide de sodium comprenant de 0,1 à 20 % en poids de réfrigérant, le réfrigérant étant un sel inorganique présentant une capacité thermique d'au moins 1400 J/K/kg.

8. Système selon une quelconque des revendications 1 à 7, le récipient (1) comprenant un contrôleur logique configuré pour déclencher l'allumeur (5) lorsque le dispositif (4) de mesure de la température du dispositif électrique atteint un seuil établi.

9. Système selon une quelconque des revendications 1 à 8, le dispositif électrique étant connecté à une source d'alimentation électrique (9), et le système de commande possédant une logique de commande qui, lorsqu'une température mesurée par le dispositif (4) (iii) est supérieure à un seuil, coupe la source d'alimentation électrique (9) et déclenche l'allumeur (5).

10. Méthode de prévention d'un incendie dans un dispositif électrique relié à une source d'alimentation électrique (9) par
(a) la mesure d'un niveau d'indicateur d'incendie, comprenant la mesure de la température, d'un niveau de monoxyde de carbone et/ou de niveau de particules de fumée dans le dispositif électrique ;
(b) la coupure de la source d'alimentation électrique (9) du dispositif électrique (3) lorsque deux des trois niveaux d'indicateur d'incendie mesurés à l'étape (a) sont supérieurs à des seuils ; et
(c) la fourniture d'un débit de gaz inerte, produit par un générateur de gaz propulseur solide (6), au dispositif électrique au bout d'un délai prédéterminé, le délai prédéterminé étant de préférence compris entre 1 et 10 secondes.

11. Méthode selon la revendication 10, la température du gaz inerte étant comprise entre 2 et 10 °C au-dessus de la température du générateur de gaz propulseur solide (6).

12. Méthode selon une quelconque des revendications 10 à 11, le gaz inerte étant du gaz azote, qui est
préparé in-situ à partir d'une composition comprenant de l'azide de sodium solide, et, de préférence, la composition comprenant de l'azide de sodium étant une matière poreuse solide présentant une porosité comprise entre 20 et 75 % en volume, et étant une composition comprenant, en fonction du poids de la composition totale d'azide de sodium de 60 à 90 % en poids d'azide de sodium, et comprenant en outre un réfrigérant, un liant et un agent modificateur.

13. Méthode selon la revendication 12, la composition comprenant de l'azide de sodium comprenant de 0,1 à 20 % en poids du réfrigérant, le réfrigérant étant un sel inorganique présentant une capacité thermique d'au moins 1400 J/K/kg.

14. Méthode selon une quelconque des revendications 12-13, la composition comprenant de l'azide de sodium comprenant en outre de 0,1 à 20 % en poids d'agent modificateur sélectionné parmi des oxydes métalliques et des carbonates métalliques, et de 3 à 15 % en poids d'un liant sélectionné parmi un silicate de métal alcalin ou un poly-tétrazole, en fonction du poids total de la composition.

15. Méthode selon une quelconque des revendications 10-14, telle qu'elle est exécutée dans un système selon les revendications 1-9.
